# EUROPÄISCHE PATENTSCHRIFT

(11) **EP 0 511 334 B1**
(45) Veröffentlichungstag und Bekanntmachung des Hinweises auf die Patenterteilung: **01.02.1995**
(21) Anmeldenummer: 91918550.4
(22) Anmeldetag: 01.11.1991
(51) Int. Cl.: B41F 15/36

(54) **VORRICHTUNG FÜR DEN LÖT- ODER LEITPASTENDRUCK**
SOLDER OR CONDUCTIVE PASTE PRINTING DEVICE
DISPOSITIF POUR L'IMPRESSION DE PATE A SOUDER OU DE PATE CONDUCTRICE

(30) Priorität: 19.11.1990 CH 3664/90; 31.12.1990 DE 9017591 U
(43) Veröffentlichungstag der Anmeldung: 04.11.1992
(73) Patentinhaber: PRSS- MASCHINEN AG, 8401 Winterthur (CH)
(72) Erfinder: HOLDEREGGER, Jürg, CH-8452 Dätwil/Adlikon (CH)
(74) Vertreter: Lauer, Joachim, Dr.
(86) Internationale Anmeldenummer: CH9100224
(87) Internationale Veröffentlichungsnummer: WO9208616

(56) Entgegenhaltungen:
- EP-A- 0 107 951
- DE-A- 1 802 686

## Beschreibung

Die Erfindung betrifft eine Vorrichtung für den Löt- oder Leitpastendruck mit einem Rahmen zum Spannen der geätzten, gefrästen oder lasergeschnittenen Druckplatten aus Metall oder Kunststoff, die mit Hilfe von Einhänglöchern und Bolzen an mindestens zwei einander gegenüberliegenden Seiten des Rahmens gehalten sind.

Für kleine Formate sind derartige Vorrichtungen bisher so konstruiert, dass die relativ dünnen Druckplatten, die gewöhnlich Dicken von einigen Zehntelmillimeter haben, mit ihren Einhänglöchern in die Bolzen des Rahmens eingefädelt und durch Balken fixiert sind, die über Schraubenbolzen an dem Rahmen befestigt sind.

Für hohe Genauigkeitsansprüche und/oder grössere Formate sind die Druckplatten bisher mit einem Drucksieb verklebt worden, das anschliessend im Bereich der Druckplatte ausgeschnitten und dann in einem Druckrahmen ausgespannt worden ist.

Beide Arten der Verbindung zwischen Druckplatte und Rahmen ermöglichen einen Wechsel der Druckplatte nur mit einem erheblichen Aufwand, bei dem der Rahmen jeweils vom "Drucktisch" entfernt und nach dem Wechsel wieder neu positioniert werden muss.

Aufgabe der Erfindung ist es, eine Vorrichtung zu schaffen, bei der ein Wechsel der Druckplatte vorgenommen werden kann, ohne dass der Rahmen jedesmal weggenommen und wieder neu montiert werden muss.

Mit der Erfindung wird diese Aufgabe dadurch gelöst, dass eine der beiden einander gegenüberliegenden Rahmenseiten als relativ zur anderen beweglicher Zugbalken ausgebildet ist, der zum Spannen der Platte, von gelenkig mit ihm verbundenen, federnd gelagerten Führungsbolzen geführt, gegenüber einem zur anderen Rahmenseite einen festen Abstand aufweisenden Widerlager verschiebbar ist, dass ferner längs jeder der beiden Rahmenseiten in der Platte aufnehmenden Arbeitsebene des Rahmens ein Halteband für die Platte angeordnet ist, auf dem eine Vielzahl mit Köpfen versehener Bolzen verteilt ist, durch die Platten unterschiedlicher Dicke mit Hilfe eines Distanzkeils in die Arbeitsebene hinein verlegt und an der jeweiligen Rahmenseite fixiert sind, wobei die Bolzen in den rahmenumschlossenen Hohlraum hinein gerichtet sind.

Durch Verschieben des Zugbalkens kann die Druckplatte ge- oder entspannt werden. Im entspannten Zustand ist es bei der neuen Konstruktion möglich, die Druckplatte mit den Einhänglöchern von oben her aus den Bolzen herauszunehmen und eine neue Druckplatte einzusetzen, ohne dass der Rahmen vom Drucktisch entfernt werden muss.

Die Haltebänder bestehen mit Vorteil aus dünnem Stahlblech, dessen Elastizität während des Druckens ein einwandfreies Aufliegen der Druckplatte auf dem zu bedruckenden Gut gewährleistet.

Um zu verhindern, dass eine Platte falsch in den Rahmen eingelegt wird, ist es vorteilhaft, wenn bei mindestens einem der Haltebänder die Bolzen unsymmetrisch zur sich senkrecht zu den Haltebändern erstreckenden Mittelebene verteilt sind. Für das Verschieben des Zugbalkens hat es sich als zweckmässig erwiesen, wenn dieser als Hohlprofil ausgebildet ist, in das in Längsrichtung als Spannmittel ein über ein Druckhalteventil mit einem Druckmittel, z. Beispiel Luft, beaufschlagbarer Schlauch eingelegt ist; dieser hat mit Vorteil einen rechteckigen Querschnitt, sowie eine verstärkte Vorderwand und im entspannten Zustand balgartig gefaltete Seitenwände.

Ein sehr genaues Positionieren der Druckplatte relativ zum Rahmen wird - bei gleichzeitigem Vermeiden von inneren Spannungen in der und damit Verwerfungen der Druckplatte - erleichtert, wenn in der Mittelebene jeder Rahmenseite ein Bolzen bzw. in der Platte je ein zugehöriges Einhängloch angeordnet sind, die als Zentrier- und Positioniereinrichtung mit ihren Durchmessern passgenau aneinander angepasst sind, während die restlichen Einhänglöcher als die Bolzen mit Spiel umgebende Langlöcher ausgebildet sind. Ein über die ganze Rahmenseite gleichmässiges Spannen kann dabei erreicht werden, wenn die Langlöcher eine senkrecht zur Mittelebene verlaufende, gerade Anlegekante aufweisen.

Im folgenden wird die Erfindung anhand eines Ausführungsbeispiels im Zusammenhang mit der Zeichnung näher erläutert.
- Fig. 1: zeigt teilweise im Schnitt eine Aufsicht auf den Rahmen der neuen Vorrichtung;
- Fig. 2: ist der Schnitt II - II von Fig. 1;
- Fig. 3: stellt eine Aufsicht auf eine Ausführungsform der neuen Druckplatte dar;
- Fig. 4: stellt als vergrössertes Detail aus Fig. 1 eine Aufsicht auf das in der Mittelebene liegende Einhängloch der Platte dar;
- Fig. 5: gibt, ebenfalls vergrössert, eine Aufsicht auf ein Langloch wieder, während
- Fig. 6: ein Schnitt VI - VI von Fig. 4 ist.

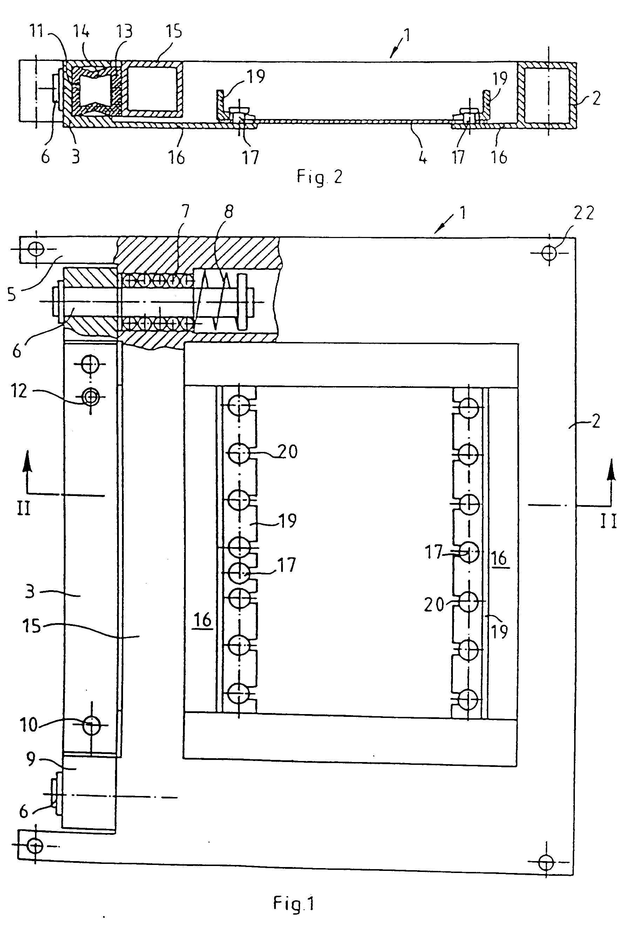

In einem rechteckigen Rahmen 1 (Fig. 1), der aus im Querschnitt ebenfalls rechteckigen Hohlprofilen (Fig. 2) zusammengesetzt ist, ist zwischen einer festen Rahmenseite 2 rechts und einer als Zugbalken 3 ausgebildeten, gegenüber der festen Rahmenseite 2 verschiebbaren Rahmenseite links eine nur schematisch dargestellte Druckplatte oder -folie 4 (Fig. 2) ausgespannt. Die Bewegung des Zugbalkens 3, der an zwei Seiten von Auslegerarmen 5 des Rahmens 1 überragt ist, wird geführt durch zwei Führungsbolzen 6; diese sind über Linearkugellager 7 im Rahmen 1 gelagert und über Federn 8 abgestützt.

Die Verbindung zwischen dem Zugbalken 3 und den Führungsbolzen 6 erfolgt über Gelenke 9, die kleine Drehbewegungen sowohl um die Führungsbolzen 6 als auch senkrecht dazu um Zapfen 10 ausführen können, durch die sie mit dem Balken 3 verbunden sind. Die gelenkige "Aufhängung" 3 des Zugbalkens erlaubt diesem, kleinen Ungleichmässigkeiten beim Spannen der Druckplatte 4 nachzugeben und so ein Klemmen zu vermeiden.

Der Zugbalken 3 ist ein im Querschnitt U-förmiges Hohlprofil (Fig. 2), in dem als "Antrieb" zum Spannen der Druckplatte 4 ein - über ein Rückschlagventil 12 aufblasbarer Schlauch 11 gelagert ist. Dieser hat einen rechteckigen Querschnitt, eine verstärkte vorderwand 13 und balgartig faltbare Seitenwände 14.

Beim Aufblasen dehnt sich der Schlauch 11 aus, verschiebt den Zugbalken 3 in Fig. 1 nach links und spannt auf diese Weise die Druckplatte 4, wobei er sich mit seiner Vorderwand 13 an einem Widerlager 15 abstützt, das parallel zur festen Rahmenseite 2 in den Rahmen 1 integriert ist.

In den Ecken des Rahmens 1 sind Gewindebohrungen 22 vorhanden; in diese können nicht gezeigte Mikrometerschrauben eingeschraubt werden, mit denen die Höhe des Rahmens 1 relativ zur bedruckenden Fläche verändert werden kann.

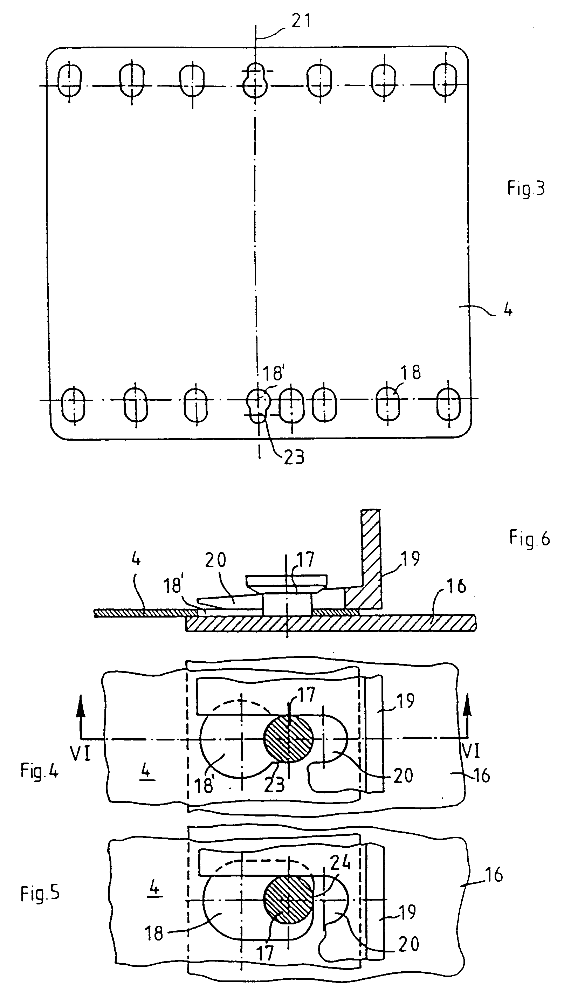

An der Rahmenseite 2 und am Zugbalken 3 sind in der Arbeitsebene der Druckplatte 4 je ein Halteband 16 vorgesehen, auf dem eine Vielzahl T-förmiger Bolzen 17 verteilt sind. Wie Fig. 1 erkennen lässt, ist die Verteilung der Bolzen 17 auf einem Halteband 16 unsymmetrisch; durch eine solche Verteilung wird sichergestellt, dass die Druckplatte 4, die entsprechend angeordnete und verteilte Einhänglöcher 18 (Fig. 3) hat, nur in einer einzigen Position in den Rahmen 1 eingelegt werden kann.

Die Fixierung der Druckplatte 4 auf den Haltebändern 16 erfolgt mit Hilfe von Distanzkeilen 19, die in Lage und Abmessungen an die Bolzen 17 angepasste Einschnitte 20 haben. Mit ihrer Keilform, die eine Fixierung unterschiedlich dicker Druckplatten 4 ermöglicht, untergreifen die Distanzkeile 19 beim Einschieben die T-förmigen Bolzen 17 und fixieren die Druckplatte 4 so auf den Haltebändern 16 (Fig. 6); gleichzeitig halten die Distanzkeile 19 die Platte 4 dabei in der Arbeitsebene.

Wie Fig. 3 zeigt, sind in der Druckplatte 4 zwei verschiedene Einhänglöcher 18 vorgesehen: in der Mittelebene 21 sind birnenartig geforme Einhänglöcher 18' vorhanden, deren Hals 23 passgenau an den Durchmesser der zugehörigen Bolzen 17 angepasst ist; darüberhinaus ist der Hals 23 in der Mittelebene 21 zentriert. Die Mittelebene 21 kann auf diese Weise als Nullinie für die x-Koordinate eines nicht gezeigten xy-Koordinatensystems dienen, mit dem die Lage bestimmter ausgezeichneter Punkte auf der Druckplatte exakt festgelegt werden kann. Die ebenfalls nicht gezeigte Null-Linie der zugehörigen y-Koordinate liegt dabei auf der zur Ebene 21 senkrechten Mittellinie der Druckplatte 4.

Die restlichen Einhänglöcher 18 sind als Langlöcher ausgeformt, in denen die Bolzen 17 sich in seitlicher Richtung frei bewegen können. Dadurch werden beim Spannen der Druckplatte Spannungen und "Verwerfungen" in ihr vermieden. Wie Fig. 5 zeigt, sind bei den Langlöchern 18 die Kanten 24, die bei gespannter Druckplatte 4 an den Bolzen 17 anliegen als Geradenstücke ausgeführt; dies erleichtert die Gleichverteilung der Spannkräfte auf die ganze Länge der Druckplatte 4.

## Patentansprüche

1. Vorrichtung für den Löt- oder Leitpastendruck mit einem Rahmen (1) zum Spannen der geätzten, gefrästen oder lasergeschnittenen Druckplatten (4) aus Metall oder Kunststoff, die mit Hilfe von Einhänglöchern (18) und Bolzen (17) an mindestens zwei, einander gegenüberliegenden Seiten (2, 3) des Rahmens (1) gehalten sind, dadurch gekennzeichnet, dass eine der beiden Rahmenseiten als ein relativ zur anderen beweglicher Zugbalken (3) ausgebildet ist, der zum Spannen der Platte (4), von gelenkig mit ihm verbundenen, federnd gelagerten Führungsbolzen (6) geführt, gegenüber einem zur anderen Rahmenseite (2) einen festen Abstand aufweisenden Widerlager (15) verschiebbar ist, dass ferner längs jeder der beiden Rahmenseiten (2, 3) in der die Platte (4) aufnehmenden Arbeitsebene des Rahmens (1) ein Halteband (16) für die Platte (4) angeordnet ist, auf dem eine Vielzahl mit Köpfen versehener Bolzen (17) verteilt ist, durch die Platten (4) unterschiedlicher Dicke mit Hilfe eines Distanzkeils (19) in die Arbeitsebene hinein verlegt und an der jeweiligen Rahmenseite (2 bzw. 3) fixiert sind, wobei die Bolzen (17) von der Arbeitsebene in den rahmenumschlossenen Hohlraum hinein gerichtet sind.

2. Vorrichtung nach Anspruch 1, dadurch gekennzeichnet, dass bei mindestens einem der Haltebänder (16) die Bolzen (17) unsymmetrisch zur sich senkrecht zu den Haltebändern (16) erstreckenden Mittelebene (21) des Rahmens (1) verteilt sind.

3. Vorrichtung nach Anspruch 1 oder 2, dadurch gekennzeichnet, dass die Haltebänder (16) aus Stahl bestehen.

4. Vorrichtung nach einem der Ansprüche 1 bis 3, dadurch gekennzeichnet, dass der Zugbalken (3) als Hohlprofil ausgebildet ist, in das in Längsrichtung als Spannmittel ein über ein Druckhalteventil (12) mit einem Druckmittel beaufschlagbarer Schlauch (11) eingelegt ist.

5. Vorrichtung nach Anspruch 4, dadurch gekennzeichnet, dass der Schlauch (11) einen rechteckigen Querschnitt, sowie eine verstärkte Vorderwand (13) und im entspannten Zustand balgartig gefaltete Seitenwände (14) hat.

6. Vorrichtung nach einem der Ansprüche 1 bis 5, dadurch gekennzeichnet, dass in der Mittelebene (21) jeder Rahmenseite (2, 3) ein Bolzen (17) bzw. in der Platte (4) je ein zugehöriges Einhängloch (18') angeordnet sind, die als Zentrier- und Positioniereinrichtung mit ihren Durchmessern passgenau aneinander angepasst sind, während die restlichen Einhänglöcher (18) als die Bolzen (17) mit Spiel umgebende Langlöcher ausgebildet sind.

7. Vorrichtung nach Anspruch 6, dadurch gekennzeichnet, dass die Langlöcher (18) eine senkrecht zur Mittelebene (21) verlaufende, gerade Anlegekante (24) aufweisen.

8. Druckplatte für den Löt- oder Leitpastendruck zur Verwendung in einer Vorrichtung nach einem der Ansprüche 1 bis 7 mit Einhänglöchern (18, 18') entlang der Ränder mindestens zweier ihrer einander gegenüberliegenden Seiten (2,3), dadurch gekennzeichnet, dass an beiden Rändern der Platte (4) jeweils ein Einhängloch (18') zur Verbesserung der Positionierung und Zentrierung der Platte in der Vorrichtung mit einer sich nach aussen zum jeweiligen Rand hin verringernden Breite versehen ist.

9. Druckplatte nach Anspruch 8, dadurch gekennzeichnet, dass die übrigen Einhänglöcher (18) als Langlöcher ausgebildet sind und randseitig eine im wesentlichen gerade Kante (24) aufweisen.

10. Druckplatte nach Anspruch 8, dadurch gekennzeichnet, dass die Einhänglöcher (18, 18') entlang eines Randes unsymmetrisch ihrer Mittelebene (21) angeordnet sind.

## Claims

1. An apparatus for solder or conductive paste printing having a frame (1) for mounting an etched, milled or laser-cut printing plate (4) made of metal or plastic, the printing plate being secured to at least two opposite sides (2,3) of the frame (1) with the help of mounting apertures (18) and bolts (17),
characterized in that,
one of the two sides of the frame is formed as a tie beam (3) which is moveable with respect to the other, the tie beam, for the mounting of the plate (4), being guided by resiliently mounted guide bolts (6) hingedly connected thereto, being displaceable with respect to an abutment (15) which is located at a fixed distance from the other side of the frame (2), and further in that along each of the two frame sides (2,3) there is provided a support band (16) for the plate (4), the support band being in the working plane of the frame (1) which receives the plate (4), there being, distributed along the support band, a plurality of bolts (17) provided with heads, by which plates (4) of differing thicknesses can, with the help of a spacer shim (19), be installed in the working plane and secured to the respective frame side (2,3), wherein the bolts (17) are directed inwardly from the working plane into the space enclosing the frame.

2. An apparatus according to claim 1, characterized in that, in at least one of the support bands (16) the bolts (17) are distributed unsymmetrically with respect to a mid-plane (21) of the frame (1) extending perpendicularly to the support bands (16).

3. An apparatus according to claim 1 or 2, characterized in that the support bands (16) are made of steel.

4. An apparatus according to one of claims 1 - 3, characterized in that the tie beam (3) is formed as a hollow extrusion, in which a tube (11), capable of being loaded with a pressure medium through a check valve (12), is inserted in the elongation direction as a tensioning means.

5. An apparatus according to claim 4, characterized in that the tube (11) has a rectangular section as well as a reinforced forward wall (13) and in the relaxed condition has bellows-like folded side walls (14).

6. An apparatus according to one of claims 1 - 5, characterized in that there is provided in the mid-plane (21) of each frame side (2, 3) a bolt bracket (17) and in the plate (4) a corresponding mounting aperture (18'), these having closely matching diameters so as to act as centering and position-establishing means, whereas the remaining mounting apertures (18) are formed as elongated apertures surrounding the corresponding bolts (17) with play.

7. An apparatus according to claim 6, characterized in that the elongated apertures (18) have straight abutment edges (24) running perpendicularly to the mid-plane (21).

8. A printing plate for solder or conductive paste printing, for use in an apparatus according to one of clams 1 - 7, having mounting apertures (18, 18') along the edges of at least two of its opposing sides (2, 3), characterized in that on both edges of the plate (4) there is provided a mounting aperture (18') for the improvement of the positioning and centering of the plate in the apparatus, said last-mentioned aperture having a decreased width in the direction toward the corresponding edge.

9. A printing plate according to claim 8, characterized in that the rest of the support apertures (18) are formed as elongated openings and are provided with a substantially straight edge (24) toward the edge of the frame.

10. A printing plate according to claim 8, characterized in that the mounting apertures (18, 18') are arranged along an edge unsymmetrically with respect to its mid-plane (21).

## Revendications

1. Dispositif pour l'impression de pâte à brasure ou de pâte conductrice avec un cadre (1) pour tendre les plaques d'impression (4) en métal ou en matières plastiques, ces plaques étant corrodées, fraisées ou découpées au laser et fixées, au moyen de trous d'accrochage (18) et de boulons (17) à au moins deux côtés (2, 3) opposés du cadre (1), **caractérisé en ce qu**'un des deux côtés du cadre est formé comme un entrait (3) mobile relativement à l'autre côté, cet entrait étant, afin de tendre la plaque (4), conduit par une broche-guide (6) reliée de manière articulée avec lui et tournant sur paliers à ressort, et mobile par rapport à une butée (15) présentant un écartement fixe relativement à l'autre côté du cadre (2) et **en ce que**, de plus, le long de chacun des deux côtés du cadre (2, 3), un collier de support (16) pour la plaque (4) est monté sur le plan de travail du cadre recevant la plaque (4), une multitude de boulons à tête (17) étant répartis sur ce collier, boulons au moyen desquels des plaques (4) d'épaisseur différente sont posées à l'intérieur du plan de travail à l'aide d'une clavette d'écartement (19) et fixées au côté correspondant (respectivement 2 ou 3), les boulons (17) étant placés du plan de travail vers l'espace vide entouré du cadre.

2. Dispositif selon la revendication 1, **caractérisé en ce que**, dans au moins un des colliers de support (16), les boulons sont répartis asymétriquement à un plan médian (21) du cadre (1), ce plan s'étendant verticalement par rapport aux colliers de support (16).

3. Dispositif selon la revendication 1 ou 2, **caractérisé en ce que** les colliers de support (16) sont en acier.

4. Dispositif selon l'une des revendications 1 à 3, **caractérisé en ce que** l'entrait (3) a la forme d'un profil creux, à l'intérieur duquel, est placé, dans le sens longitudinal, un tuyau (11) pouvant être alimenté avec un agent de pression au moyen d'une vanne de maintien de pression (12), ce tuyau servant de moyen de tension.

5. Dispositif selon la revendication 4, **caractérisé en ce que** le tuyau (11) a une section rectangulaire, ainsi qu'une paroi frontale renforcée et des parois latérales (14), qui, à l'état de détente, sont ondulées en soufflet.

6. Dispositif selon l'une des revendications 1 à 5, **caractérisé en ce que** sont placés, dans le plan médian de chaque côté du cadre (2, 3) un boulon (17) ou, dans la plaque (4) un trou d'accrochage (18') correspondant, qui, comme moyens de centrage et de positionnement, ont des diamètres ajustés exactement l'un à l'autre, alors que les trous d'accrochage restants (18) sont formés comme des trous oblongs avec du jeu.

7. Dispositif selon la revendication 6, **caractérisé en ce que** les trous oblongs (18) présentent un bord de guidage (24) droit, placé verticalement par rapport au plan médian (21).

8. Plaque pour l'impression de pâte à brasure ou de pâte conductrice pour l'utilisation dans un dispositf selon une des revendications 1 à 7, avec des trous d'accrochage (18, 18') le long des bords d'au moins deux de ses côtés opposés (2, 3), **caractérisée en ce que**, à des fins d'amélioration du positionnement et du centrage de la plaque dans le dispositif, aux deux bords de la plaque (4), un trou d'accrochage (18') a une largeur, qui, vers l'extérieur, diminue en se rapprochant du bord.

9. Plaque d'impression selon la revendication 8, **caractérisée en ce que** les trous d'accrochage restants (18) sont formés comme des trous oblongs et présentent, sur leur bord, une arête essentiellement droite.

10. Plaque d'impression selon la revendication 8, **caractérisée en ce que** les trous d'accrochage (18, 18') le long d'un côté, sont placés asymétriquement par rapport à leur plan médian (21).
